(19) Europäisches Patentamt / European Patent Office / Office européen des brevets

(11) **EP 4 672 307 A1**

(12) **EUROPEAN PATENT APPLICATION**
published in accordance with Art. 153(4) EPC


(43) Date of publication:
**31.12.2025 Bulletin 2026/01**

(21) Application number: **23924070.8**

(22) Date of filing: **24.02.2023**

(51) International Patent Classification (IPC):
***H01L 21/66** (2006.01)*

(52) Cooperative Patent Classification (CPC):
**H01L 22/00**

(86) International application number:
**PCT/JP2023/006650**

(87) International publication number:
**WO 2024/176420 (29.08.2024 Gazette 2024/35)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**



(71) Applicant: **SUMCO CORPORATION**
**Minato-ku, Tokyo 105-8634 (JP)**

(72) Inventors:
- **FUMOTO, Shuto**
  **Tokyo 105-8634 (JP)**
- **SAMATA, Shuichi**
  **Tokyo 105-8634 (JP)**
- **MITSUGI, Noritomo**
  **Tokyo 105-8634 (JP)**

(74) Representative: **Kraus & Lederer PartGmbB**
**Thomas-Wimmer-Ring 15**
**80539 München (DE)**


# (54) SEMICONDUCTOR SAMPLE EVALUATION METHOD, SEMICONDUCTOR SAMPLE EVALUATION DEVICE, AND SEMICONDUCTOR WAFER MANUFACTURING METHOD


(57) Provided is a semiconductor sample evaluation method including acquiring, a plurality of times, a decay curve by performing measurement on a semiconductor sample which is an evaluation target in accordance with a photoconductive decay method while changing a surface charge density; performing signal data processing using a model expression including an exponential decay term and a constant term on at least one decay curve among decay curves obtained through the plurality of measurements; obtaining a recombination lifetime $\tau_{eff}$ of the semiconductor sample from an exponential decay expression obtained through the signal data processing; obtaining a quadratic function, in which a surface charge density related value is represented by a variable x and a value related to the constant term is represented by a variable y, from measurement results obtained through the plurality of measurements; and obtaining a surface recombination lifetime $\tau_s$ of the semiconductor sample from the quadratic function.


Fig. 5

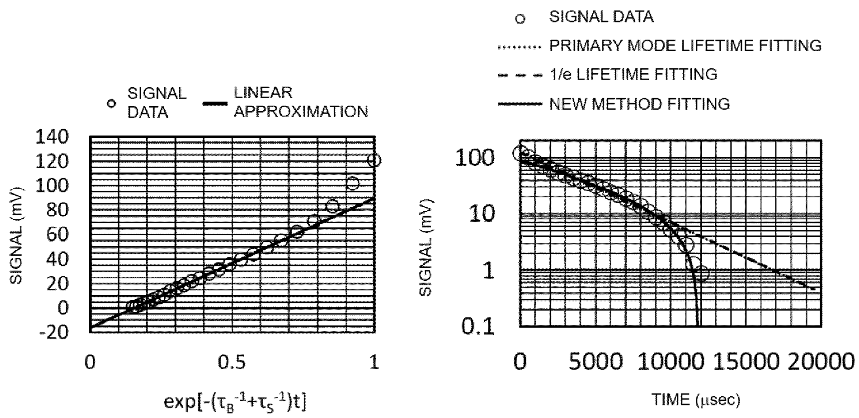





Processed by Luminess, 75001 PARIS (FR)

## Description

Technical Field

The present invention relates to a semiconductor sample evaluation method, a semiconductor sample evaluation device, and a semiconductor wafer manufacturing method.

Background Art

A photoconductivity decay method is generally called a PCD method and is widely used for evaluating a semiconductor sample.

Citation List

Patent Literature

PTL 1: Japanese Patent Application Publication No. 2019-012740
PTL 2: Japanese Patent Application Publication No. S58-181549

Non Patent Literature

NPL 1: Akira Usami, Fukuyasu Sone, Koji Murai, and Kenji Sano, Laser Research 1984, Vol. 12, No. 10, p. 585-594
NPL 2: Akira Usami, Shinichi Kandatsu, and Takeshi Kudo, Applied Physics, Vol. 49, No. 12, 1980, p. 1192-1197

Summary of Invention

Technical Problem

For example, for silicon wafers, which are an example of semiconductor samples, a method of measuring a recombination lifetime through the PCD method is standardized (SEMI MF1535. Test Methods for Carrier Recombination Lifetime in Silicon Wafers by Noncontact Measurement of Photoconductivity Decay by Microwave Reflectance. 2007; hereafter referred to as a "SEMI standard").

The above-mentioned SEMI standard describes a primary mode method and a 1/e lifetime method as methods of determining the recombination lifetime through the PCD method. In the primary mode method, a time constant in a range where a decay curve acquired through the measurement according to the PCD method may be considered as exponential decay is defined as a primary mode lifetime $\tau_1$. The primary mode lifetime $\tau_1$ is represented by the expression: $1/\tau_1 = 1/\tau_b + 1/\tau_s$, which employs a Shockley-Read-Hall (SRH) recombination lifetime (that is, bulk lifetime) $\tau_b$ and a surface recombination lifetime $\tau_s$. In contrast, in the 1/e lifetime method, assuming that a time during which excess carriers are excited in the semiconductor sample by the light pulses is $t_0$ and a time elapsed until a signal intensity V is equal to 1/e times ($V_1 = V_0/e$) a peak value $V_0$ of the signal intensity V is $t_1$, a 1/e lifetime $\tau_e$ is represented by the expression: $\tau_e = t_1 - t_0$.

In the above-mentioned method, the recombination lifetime is calculated under the assumption that the decay of the excess carrier concentration is in a form of exponential decay caused by contribution of only the SRH recombination (that is, bulk recombination). However, as described in PTL 2, for example, the recombination lifetime (described as "effective lifetime $\tau_{eff}$" in PTL 2) relates to the surface recombination lifetime $\tau_s$ in addition to the SRH recombination lifetime (bulk lifetime) $\tau_b$, which is determined by a purity of a semiconductor crystal of a semiconductor sample which is an evaluation target, a crystal defect, and the like. For example, in a silicon wafer having a high level of cleanliness, the contribution of the SRH recombination is relatively lowered. Thus, the contribution of the surface recombination and the like are not ignorable. Therefore, for example, in a case where the PCD measurement is performed on the silicon wafer having a high level of cleanliness, the decay curve is distorted due to the effect of surface recombination, for example, at the end of the decay, becoming a non-exponential decay. For example, in such a case, it is difficult to accurately measure the recombination lifetime in the above-mentioned method, which is performed under the assumption that the decay of the excess carrier concentration is in the form of exponential decay caused by the contribution of only the SRH recombination.

Regarding the surface recombination, PTL 1, PTL 2, NPL 1, and NPL 2 have proposed evaluation methods in which the surface recombination is taken into consideration. However, the method proposed in PTL 1 requires two measurements per sample, which is not suitable for samples whose recombination lifetime depends on the elapsed time from the surface treatment, and it is necessary to create a database for analysis. Accordingly, it is not appropriate for general use. In addition, the methods proposed in PTL 2, NPL 1, and NPL 2 are all methods of canceling out deviation from exponential decay, which is caused in the initial stage of decay by the effect of a mode having a higher order than the primary mode, as the effect of the surface recombination. Consequently, the methods cannot reduce or cancel out the effect of the deviation from exponential decay in the final stage of the decay.

With the foregoing in view, according to an aspect of the present invention, it is an object to provide a new evaluation method for accurately evaluating the recombination lifetime of the semiconductor sample.

Solution to Problem

As a result of extensive research, the present inventors have newly found that it is possible to accurately determine a recombination lifetime $\tau_{eff}$ by performing signal data processing on the decay curve as follows. Further, the present inventors have newly found that it is possible to obtain a surface recombination lifetime $\tau_s$ in addition to the recombination lifetime $\tau_{eff}$ by using a model expression as follows.

An aspect of the present invention is as follows.

[1] A semiconductor sample evaluation method including:

acquiring, a plurality of times, a decay curve by performing measurement on a semiconductor sample which is an evaluation target in accordance with a photoconductive decay method while changing a surface charge density;
performing signal data processing using a model expression including an exponential decay term and a constant term on at least one decay curve among decay curves obtained through the plurality of measurements;
obtaining a recombination lifetime $\tau_{eff}$ of the semiconductor sample from an exponential decay expression obtained through the signal data processing;
obtaining a quadratic function, in which a surface charge density related value is represented by a variable x and a value related to the constant term is represented by a variable y, from measurement results obtained through the plurality of measurements; and
obtaining a surface recombination lifetime $\tau_s$ of the semiconductor sample from the quadratic function.

[2] The semiconductor sample evaluation method according to [1], wherein the surface recombination lifetime $\tau_s$ is calculated from Expression (11)' below represented by

$$C_{min} = \tau_{eff}/\tau_s \times n_0: \ldots (11)',$$

(in Expression (11)', $n_0$ is an equilibrium carrier concentration),
where $C_{min}$ is a minimum value of y in the quadratic function.

[3] The semiconductor sample evaluation method according to [1] or [2], further including:
obtaining an SRH recombination lifetime $\tau_b$ of the semiconductor sample from the recombination lifetime $\tau_{eff}$ and the surface recombination lifetime $\tau_s$.
[4] The semiconductor sample evaluation method according to [3], wherein
the SRH recombination lifetime $\tau_b$ is obtained from Expression (1)' below represented by

$$1/\tau_{eff} = 1/\tau_b + 1/\tau_s \ldots (1)'.$$

[5] The semiconductor sample evaluation method according to any one of [1] to [4], further including:
obtaining a surface recombination rate $S_r$ of the semiconductor sample from a thickness d of the semiconductor sample and the surface recombination lifetime $\tau_s$ through Expression (12) below represented by

$$S_r = d/(2\tau_S) \ldots (12).$$

[6] The semiconductor sample evaluation method according to any one of [1] to [5], further including:

acquiring the exponential decay expression by performing the signal data processing to cancel out the constant term in the model expression; and

obtaining a time constant $\tau_b^{-1}+\tau_S^{-1}$ from the exponential decay expression, wherein $\tau_b$ is an SRH recombination lifetime, and $\tau_S$ is the surface recombination lifetime.

[7] The semiconductor sample evaluation method according to [6], wherein the signal data processing includes repeating an operation of sampling a time-series signal modeled by the model expression and taking a difference.
[8] The semiconductor sample evaluation method according to [7], further including: performing autoscaling to determine a sampling region in which the sampling is performed.
[9] The semiconductor sample evaluation method according to [8], wherein the autoscaling determines a region, which is less affected by Auger recombination and less affected by noise, as the sampling region.
[10] The semiconductor sample evaluation method according to any one of [1] to [9], wherein

the model expression is Expression (10)' below represented by

$$xi(ti) = A\times\exp[-(\tau_b^{-1}+\tau_S^{-1})ti]-C \ ... \ (10)'$$

(in Expression (10)', ti is a time elapsed after irradiation with excitation light, xi(ti) is a signal intensity at the elapsed time ti, $\tau_b$ is an SRH recombination lifetime, $\tau_S$ is the surface recombination lifetime, and A and C are constants).

[11] The semiconductor sample evaluation method according to any one of [1] to [10], further including:

calculating the surface recombination lifetime $\tau_s$ from Expression (11)' below represented by

$$C_{min} = \tau_{eff}/\tau_s\times n_0: \ ... \ (11)'$$

(in Expression (11)', $n_0$ is an equilibrium carrier concentration),
where $C_{min}$ is a minimum value of y in the quadratic function;
obtaining an SRH recombination lifetime $\tau_b$ of the semiconductor sample from the recombination lifetime $\tau_{eff}$ and the surface recombination lifetime $\tau_s$;
obtaining the SRH recombination lifetime $\tau_b$ from Expression (1)' below represented by

$$1/\tau_{eff} = 1/\tau_b+1/\tau_s \ ... \ (1)';$$

acquiring the exponential decay expression by performing the signal data processing to cancel out the constant term in the model expression; and
obtaining the time constant $\tau_b^{-1}+\tau_S^{-1}$ from the exponential decay expression, wherein $\tau_b$ is the SRH recombination lifetime, and $\tau_S$ is the surface recombination lifetime, the signal data processing includes repeating an operation of sampling a time-series signal modeled by the model expression and taking a difference,
the signal data processing further includes performing autoscaling to determine a sampling region in which sampling is performed,
the autoscaling determines a region, which is less affected by Auger recombination and less affected by noise, as the sampling region, and
the model expression is Expression (10)' below represented by

$$xi(ti) = A\times\exp[-(\tau_b^{-1}+\tau_S^{-1})ti]-C \ ... \ (10)'$$

(in Expression (10)', ti is a time elapsed after irradiation with excitation light, xi(ti) is a signal intensity at the elapsed time ti, $\tau_b$ is an SRH recombination lifetime, $\tau_S$ is the surface recombination lifetime, and A and C are constants).

[12] The semiconductor sample evaluation method according to any one of [1] to [11], further including:

calculating the surface recombination lifetime $\tau_s$ from Expression (11)' below represented by

$$C_{min} = \tau_{eff}/\tau_s\times n_0: \ ... \ (11)'$$

(in Expression (11)', $n_0$ is an equilibrium carrier concentration),
where $C_{min}$ is a minimum value of y in the quadratic function;
obtaining a surface recombination rate $S_r$ of the semiconductor sample from a thickness d of the semiconductor sample and the surface recombination lifetime $\tau_S$ through Expression (12) below represented by

$$S_r = d/(2\tau_S) \ldots (12);$$

acquiring the exponential decay expression by performing the signal data processing to cancel out the constant term in the model expression; and
obtaining the time constant $\tau_b^{-1}+\tau_S^{-1}$ from the exponential decay expression, wherein $\tau_b$ is the SRH recombination lifetime, and $\tau_S$ is the surface recombination lifetime, the signal data processing includes repeating an operation of sampling a time-series signal modeled by the model expression and taking a difference,
the signal data processing further includes performing autoscaling to determine a sampling region in which sampling is performed,
the autoscaling determines a region, which is less affected by Auger recombination and less affected by noise, as the sampling region, and
the model expression is Expression (10)' below represented by

$$xi(ti) = A\times\exp[-(\tau_b^{-1}+\tau_S^{-1})ti]-C \ldots (10)'$$

(in Expression (10)', ti is a time elapsed after irradiation with excitation light, xi(ti) is a signal intensity at the elapsed time ti, $\tau_b$ is an SRH recombination lifetime, $\tau_S$ is the surface recombination lifetime, and A and C are constants).

[13] A semiconductor sample evaluation device that performs the semiconductor sample evaluation method according to any one of [1] to [12], the evaluation device including:

a measurement unit that performs measurement on a semiconductor sample which is an evaluation target in accordance with a photoconductive decay method; and
a processing unit that performs signal data processing, which uses a model expression including an exponential decay term and a constant term, on the decay curve, and obtains the quadratic function.

[14] The evaluation device according to [13], wherein
a light pulse intensity of the measurement unit is variable.
[15] The evaluation device according to [13] or [14], wherein
the measurement unit further includes a corona charging treatment unit.
[16] The evaluation device according to any one of [13] to [15], wherein
the measurement unit further includes a surface charge density related value measurement unit that measures a surface charge density related value of the semiconductor sample to be subjected to the measurement.
[17] The evaluation device according to any one of [13] to [16], wherein

a light pulse intensity of the measurement unit is variable, and
the measurement unit further includes a corona charging treatment unit and a surface charge density related value measurement unit that measures a surface charge density related value of the semiconductor sample to be subjected to the measurement.

[18] A semiconductor wafer manufacturing method including:

manufacturing a semiconductor wafer lot including a plurality of semiconductor wafers;
extracting at least one semiconductor wafer from the semiconductor wafer lot;
evaluating the extracted semiconductor wafer by the evaluation method according to any one of [1] to [12]; and
providing a semiconductor wafer, which has the same semiconductor wafer lot as a semiconductor wafer determined to be a non-defective product as a result of the evaluating, for shipment as a product semiconductor wafer.

[19] A semiconductor wafer manufacturing method including:

manufacturing an evaluation semiconductor wafer under a test manufacturing condition;

evaluating the manufactured evaluation semiconductor wafer through the semiconductor sample evaluation method according to any one of [1] to [12];

determining a manufacturing condition, which is obtained by modifying the test manufacturing condition, as an actual manufacturing condition on the basis of a result of the evaluating, or determining the test manufacturing condition as an actual manufacturing condition; and

manufacturing a semiconductor wafer under the determined actual manufacturing condition.

Effects of Invention

According to an aspect of the present invention, it is possible to accurately determine the recombination lifetime $\tau_{eff}$, and it is also possible to determine the surface recombination lifetime $\tau_s$.

Brief Description of Drawings

[Fig. 1] Fig. 1 is an explanatory diagram of a specific example of signal data processing.
[Fig. 2] Fig. 2 is an explanatory diagram of a specific example of the signal data processing.
[Fig. 3] Fig. 3 is an explanatory diagram of a specific example of the signal data processing.
[Fig. 4] Fig. 4 is an explanatory diagram of an example of a semiconductor sample evaluation method according to an aspect of the present invention.
[Fig. 5] Fig. 5 illustrates comparison results between an example of a semiconductor sample evaluation method according to an aspect of the present invention (new method) and a conventional method.
[Fig. 6] Fig. 6 illustrates comparison results between an example of a semiconductor sample evaluation method according to an aspect of the present invention (new method) and the conventional method.
[Fig. 7] Fig. 7 illustrates comparison results between an example of a semiconductor sample evaluation method according to an aspect of the present invention (new method) and the conventional method.
[Fig. 8] Fig. 8 is a schematic diagram of a plot for deriving a surface recombination lifetime $\tau_s$.
[Fig. 9] Fig. 9 illustrates a quadratic curve obtained in Example 1.
[Fig. 10] Fig. 10 illustrates a quadratic curve obtained in Example 2.
[Fig. 11] Fig. 11 illustrates a decay curve obtained by performing a chemical passivation treatment as a surface treatment on an n-type silicon wafer (single crystal silicon wafer) and then measuring the wafer through the $\mu$-PCD method.
[Fig. 12] Fig. 12 illustrates a fitting curve obtained by performing primary mode lifetime fitting on the decay curve illustrated in Fig. 11 and a fitting curve obtained by performing the 1/e lifetime fitting.

Description of Embodiments

[Semiconductor Sample Evaluation Method]

According to an aspect of the present invention, a semiconductor sample evaluation method includes: acquiring, a plurality of times, a decay curve by performing measurement on a semiconductor sample which is an evaluation target in accordance with a photoconductive decay method while changing a surface charge density; performing signal data processing using a model expression including an exponential decay term and a constant term on at least one decay curve among decay curves obtained through the above-mentioned plurality of measurements; obtaining a recombination lifetime $\tau_{eff}$ of the above-mentioned semiconductor sample from an exponential decay expression obtained through the above-mentioned signal data processing; obtaining a quadratic function, in which a surface charge density related value is represented by a variable x and a value related to the above-mentioned constant term is represented by a variable y, from measurement results obtained through the above-mentioned plurality of measurements; and obtaining a surface recombination lifetime $\tau_s$ of the above-mentioned semiconductor sample from the above-mentioned quadratic function. Hereinafter, the above-mentioned evaluation method will be described in more detail.

<Semiconductor Sample as Evaluation Target>

It is sufficient for the evaluation target of the above-mentioned evaluation method to be a semiconductor sample. Examples of the semiconductor sample includes various semiconductor samples such as single crystal silicon, polycrystalline silicon, and SiC. Shapes and dimensions of the semiconductor sample which is an evaluation target are not particularly limited. For example, the semiconductor sample which is an evaluation target may be a semiconductor sample having a shape of a wafer, that is, a semiconductor wafer such as a single crystal silicon wafer. However, the semiconductor sample which is an evaluation target may have a shape other than a wafer. Further, a conductivity type of the semiconductor sample which is an evaluation target is not particularly limited, and may be either n-type or p-type.

<Measurement According to Photoconductive Decay Method>

Well-known techniques are applicable to the measurement according to the photoconductive decay method in the above-mentioned evaluation method. A specific example of the photoconductive decay method may be a microwave photoconductive decay (μ-PCD) method. However, the measurement according to the photoconductive decay method in the above-mentioned evaluation method is not limited to the μ-PCD method. For example, considering a maximum carrier injection amount of a general μ-PCD device, in a case where the semiconductor sample which is an evaluation target is p-type silicon, a resistivity thereof is preferably in a range of about 1 to 100 Ωcm, and in a case where the semiconductor sample is n-type silicon, a resistivity thereof is preferably in a range of about 0.5 to 100 Ωcm.

In the measurement, first, light pulses excite excess carriers in the semiconductor sample which is an evaluation target. Therefore, as the PCD device, a PCD device capable of setting the light pulse intensity to a desired value (that is variable) in the measurement unit is employed, and performs the measurement by setting the light pulse intensity to an appropriate value.

Further, in order to perform measurement a plurality of times while changing a surface charge density as described later, a PCD device including a corona charging treatment unit in the measurement unit can be used, and is able to perform the measurement a plurality of times while changing the surface charge density by, for example, changing the number of corona charges. For example, a PCD device can be used which includes a corona charging treatment unit capable of applying positive, negative, or both positive and negative charges to the surface of one semiconductor sample through the corona charging method or applying positive or negative charges to the surfaces of a plurality of semiconductor samples through the corona charging method. Alternatively, in order to perform measurement a plurality of times while changing the surface charge density, the surface charge density of the semiconductor sample which is a measurement target can be changed by changing the concentration of the chemical agent (for example, iodine, quinhydrone, or the like) used in the chemical passivation treatment and/or by changing the treatment time. In such a case, it is preferable to use a PCD device having a device configuration compatible with chemical passivation. Examples of such a PCD device may include a device including a mechanism that applies a chemical agent solution (for example, an iodine ethanol solution, or the like) to the front and back surfaces of the semiconductor sample and that measures the sample which is being in a transparent bag such as polyethylene, and a device including a mechanism that applies a chemical agent solution (for example, an iodine ethanol solution, or the like) to the front and back surfaces of the semiconductor sample outside the device and that measures the sample which is being in a transparent bag such as polyethylene.

Further, as the PCD device, a device including a measurement device that measures a surface charge density related value such as an amount of surface charge and a surface potential can be used. For example, the surface charge density in each measurement can be obtained by actually measuring the amount of surface charge, the surface potential, and the like through the surface charge density related value measurement device such as a Kelvin probe or a non-contact CV measurement device. One example of the surface charge density related value measurement device may be a non-contact CV measurement device that measures the surface charge density related value by providing an air gap between a surface of the semiconductor sample and an electrode facing the surface and applying a voltage therebetween.

A decay curve is acquired through the measurement according to the above-mentioned photoconductive decay method. Specifically, the decay curve is a curve showing a time-varying change in signal intensity relative to the time elapsed after irradiation with excitation light. Specifically, the "time elapsed after irradiation with excitation light" is a time elapsed from an end time point of the irradiation with excitation light. Further, for example, in the μ-PCD method, the signal intensity is an intensity of reflected microwaves. Fig. 11 illustrates a decay curve obtained by performing a chemical passivation treatment as a surface treatment on an n-type silicon wafer (single crystal silicon wafer) and then measuring the wafer through the μ-PCD method. The decay curve illustrated in Fig. 11 is distorted from the middle to the end regions due to an effect of surface recombination. Fig. 12 illustrates a fitting curve obtained by performing primary mode lifetime fitting specified in the SEMI standard on the decay curve illustrated in Fig. 11 and a fitting curve obtained by performing the 1/e lifetime fitting specified in the SEMI standard on the decay curve. Neither of the two fitting curves illustrated in Fig. 12 fit the decay curve especially in a range of the middle to the end regions. The reason for this is that the fitting is performed under assumption that the decay of the excess carrier concentration is an exponential decay caused by the contribution of only the SRH recombination in the primary mode method and the 1/e lifetime method.

On the other hand, in the above-mentioned evaluation method, the recombination lifetime $\tau_{eff}$ can be obtained with high accuracy by performing signal data processing on the decay curve as described below in detail.

<Derivation of Recombination Lifetime $\tau_{eff}$>

(Signal Data Processing for Decay Curve)

In the above-mentioned evaluation method, the signal data processing is performed on at least one decay curve among decay curves, which are obtained by the measurement of the semiconductor sample which is an evaluation target according to the photoconductive decay method, by using a model expression including an exponential decay term and a constant term. The number of decay curves to be subjected to signal data processing may be only one, or may be two or more. In a case where the number of decay curves is two or more, for example, an average value of the recombination lifetime obtained through the signal data processing for each decay curve can be employed as the recombination lifetime $\tau_{eff}$ of the semiconductor sample which is an evaluation target. As the decay curve to be subjected to signal data processing, it is preferable to use a decay curve obtained through measurement under a measurement condition with a small surface charge density among a plurality of decay curves obtained by the plurality of measurements described above. In addition, it is more preferable to use a decay curve obtained through measurement under a measurement condition with the smallest surface charge density among the plurality of measurements. For example, in a case where the surface charge density is changed by changing the number of corona charges, it is preferable to use a decay curve obtained through measurement when the number of corona charges is zero. It is most preferable to use a decay curve obtained through measurement under a measurement condition with zero surface charge density, but in practice, generally the surface charge density can be actually measured when being greater than 0.

The above-mentioned model expression includes the constant term outside the exponential decay term. The present inventors presume that it is appropriate that the decay curve in a case where the surface recombination occurs is represented by an expression which includes an exponential decay term and a constant term, preferably, an expression in which the constant term is subtracted from the exponential decay term. By performing the signal data processing to cancel out the constant term in such an expression, only the exponential decay term remains. That is, an expression exponential decay is obtained. By using the exponential decay expression, the recombination lifetime value can be obtained as a value including the effects of the SRH recombination and the surface recombination. Thereby, it is possible to accurately obtain the recombination lifetime of the semiconductor sample which is an evaluation target. Hereinafter, such signal data processing will be described in more detail.

If an excess carrier concentration is x[1/cm$^3$] and a function of time is x(t), the function x(t) can be approximately represented by Expression (1) below.

$$x(t) = A\times\exp[-(\tau_b^{-1}+\tau_S^{-1})t]-C \ ... \ (1)$$

In Expression (1), $\tau_b$ represents the SRH recombination lifetime, with a unit of, for example, μsec, and $\tau_S$ represents the surface recombination lifetime, with a unit of, for example, μsec. A and C each independently represent a constant [1/cm$^3$], preferably, a positive constant. A and C are constants determined depending on $\tau_b^{-1}+\tau_S^{-1}$. In a case where both the SRH recombination and the surface recombination due to surface levels contribute to the recombination lifetime, Expression (1) described above is a suitable function under a condition that the excess carrier concentration is greater than a carrier concentration in an equilibrium state, with the excess carrier concentration being a function of time x(t).

As a model expression for performing signal data processing on the basis of Expression (1), Expression (10)' below can be exemplified.

$$xi(ti) = A\times\exp[-(\tau_b^{-1}+\tau_S^{-1})ti]-C \ ... \ (10)'$$

In Expression (10)', ti is a time elapsed after irradiation with excitation light, xi(ti) is a signal intensity at the elapsed time ti, the unit thereof is, for example, mV, $\tau_b$ is an SRH recombination lifetime, $\tau_S$ is a surface recombination lifetime, A and C are each independently constants, and the unit thereof is, for example, mV. The above-mentioned model Expression (10)' includes an exponential decay term and a constant term, and specifically, the constant term "C" is subtracted from the exponential decay term "$A\times\exp[-(\tau_b^{-1}+\tau_s^{-1})ti]$". Expression (10)' is an example of the above-mentioned model expression. For example, in a case where the signal data processing is performed to cancel out the constant term in the model expression such as Expression (10)' including the constant term, only the exponential decay term remains. Therefore, the time constant $\tau_b^{-1}+\tau_S^{-1}$ (a sum of a reciprocal of the surface recombination lifetime and the reciprocal of the SRH recombination lifetime) can be obtained through the exponential decay approximation method. The reciprocal of $\tau_b^{-1}+\tau_S^{-1}$ obtained in such a manner can be employed as a value of the recombination lifetime $\tau_{eff}$ of the semiconductor sample which is an evaluation target. As the exponential decay approximation method, a general exponential decay approximation method such as the 1$^{st}$-order lifetime method or the 1/e lifetime method can be used.

Hereinafter, in an exemplary case where the above-mentioned model expression is Expression (10)', a specific example of the signal data processing will be described. However, the signal data processing described below is merely an example, and the present invention is not limited to such an example.

The signal data processing may include repeating an operation of determining a sampling region in the decay curve acquired through the measurement according to the photoconductive decay method, sampling a time-series signal (more specifically, measurement points on the decay curve) modeled by the above-mentioned model expression in the sampling region, and acquiring a difference therebetween. The sampling region can be determined, for example, by autoscaling, and the following method can be given as a specific example. For example, according to the following method, a region, which is less affected by Auger recombination and less affected by noise, can be determined as the sampling region. That is, a region, which is greatly affected by the Auger recombination and has a high signal intensity, and a region, which is greatly affected by noise and has a low signal intensity, are eliminated in the decay curve acquired through measurement according to the photoconductive decay method. Thereby, it is possible to set a region having strong effects of SRH recombination and surface recombination as the sampling region.

First, a position of an optional signal intensity (for example, 60% of a peak value) is set as a start point of the sampling region, and the signal data processing is executed once. From the calculation results obtained through the signal data processing, a value that can be used as an index of a degree of conformity to exponential decay, such as an $R^2$ value or a sum of squares of residuals, is calculated. The degree of conformity to exponential decay is evaluated on the basis of whether the calculated value of such an index satisfies a preset threshold value.

If the above-mentioned calculated value satisfies a preset threshold value (for example, $R^2 \geq 0.99$), the start point of the sampling region which is set above can be determined as the start point of the sampling region when the signal data processing is executed.

If the above-mentioned calculated value does not satisfy the preset threshold value (for example, $R^2 \geq 0.99$), the start point of the sampling region is shifted to a side with a lower signal intensity and recalculation is performed. The recalculation can be performed once or twice or more. If the evaluation result of the recalculation satisfies the preset threshold value, the start point in the recalculation can be determined as the start point of the sampling region.

The end point of the sampling region can be set as a position where an SN ratio (signal-to-noise ratio) is equal to or less than a preset threshold value. The SN ratio can be calculated, for example, by the following expression. The threshold value of the above-mentioned SN ratio may be equal to or less than, for example, 5 dB. It is preferable to determine the end point at a position where the SN ratio of the signal is 0 dB, that is, a position where the noise and the signal are at approximately the same level.

$$\text{SN ratio [dB]} = 20\log_{10}[(\text{variance of signal at any time})/(\text{variance of noise in equilibrium})]$$

Figs. 1 to 3 are explanatory diagrams of a specific example of the signal data processing. Assuming that the number of sampling points is, for example, 3N, the signal data processing can be performed as follows. Here, N is an optional integer, and can be, for example, 2 or more. Further, N can be equal to or less than, for example, 333 if the total number of points of the signal data is 1000. That is, N can be, for example, an integer equal to or less than "$T \times 1/3$" if the total number of points of the signal data is T.

First, using the start point (1st point) as a reference, an average $A_1$ thereof at 1st to Nth points and an average $B_1$ thereof at (N+1)th to 2Nth points are calculated (refer to Fig. 1).

$$A_1 = \{x(t_1)+x(t_2)+ \ldots +x(t_N)\}/N$$

$$B_1 = \{x(t_{N+1})+x(t_{N+2})+ \ldots +x(t_{2N})\}/N$$

$Y(t_1)$ is a value obtained by subtracting $B_1$ from $A_1$.

$$Y(t_1) = A_1-B_1$$

Next, using the 2nd point as a reference, an average $A_2$ of 2nd to (N+1)th points and an average $B_2$ of (N+2)th to (2N+1)th points are calculated (refer to Fig. 2).

$$A_2 = \{x(t_2)+x(t_3)+ \ldots +x(t_{N+1})\}/N$$

$$B_2 = \{x(t_{N+2})+x(t_{N+3})+ \ldots +x(t_{2N+1})\}/N$$

$Y(t_2)$ is a value obtained by subtracting $B_2$ from $A_2$.

$$Y(t_2) = A_2-B_2$$

Continuing the same calculation, finally an average $A_{N+1}$ of $(N+1)^{th}$ to $2N^{th}$ points and an average $B_{N+1}$ of $(2N+1)^{th}$ to $3N^{th}$ points are calculated (refer to Fig. 3).

$$A_{N+1} = \{x(t_{N+1})+x(t_{N+2})+ \ldots +x(t_{2N})\}/N$$

$$B_{N+1} = \{x(t_{2N+1})+x(t_{2N}+_2)+ \ldots +x(t_{3N})\}/N$$

$Y(t_{N+1})$ is a value obtained by subtracting $B_{N+1}$ from $A_{N+1}$.

$$Y(t_{N+1}) = A_{N+1}-B_{N+1}$$

A time-series signal data sequence obtained by continuing the above-mentioned calculations is Expression (2) of the following exponential decay with the constant term canceled out in Expression (10)'. The time constant $\tau_b^{-1}+\tau_S^{-1}$ can be obtained by applying a general exponential decay approximation method to Expression (2). The term "$\tau_b^{-1}+\tau_S^{-1}$" obtained in such a manner can be employed as a value of the recombination lifetime $\tau_{eff}$ of the semiconductor sample which is an evaluation target. Examples of the above-mentioned exponential decay approximation method include the primary mode method and the 1/e lifetime method.

$$Y(t) = A'\times\exp[-(\tau_b^{-1}+\tau_S^{-1})t] \ldots (2)$$

(A': optional constant)

(Specific Embodiment of Method of Calculating Recombination Lifetime $\tau_{eff}$)

Fig. 4 is an explanatory diagram of an example of a semiconductor sample evaluation method according to an aspect of the present invention.

A decay curve illustrated in a left figure of Fig. 4 is the same as a decay curve illustrated in Fig. 11. The decay curve is a decay curve obtained by subjecting an n-type silicon wafer (single crystal silicon wafer, resistivity: 10 Ωcm) to measurement according to the μ-PCD method after performing the chemical passivation treatment as a surface treatment. Here, a maximum carrier injection amount of the μ-PCD was about $1E17/cm^3$. "E17" indicates "$\times10^{17}$".

Regarding the decay curve illustrated in the left figure of Fig. 4, Equation (10)' was used as a model expression. As described above with reference to Figs. 1 to 3, the number of sampling points was set to 3N, and signal data processing was performed. The start point of the sampling region was determined in accordance with the method described above with the threshold value as "$R^2 \geq 0.99$". The end point of the sampling region was set to a position where the SN ratio was 0 dB, as described above.

By performing the above-mentioned signal data processing, the constant term of Equation (10)' was canceled out, and a straight line (solid line in a right figure of Fig. 4) of a primary expression of Equation (2) formed of only the exponential decay term was obtained. The time constant $\tau_b^{-1}+\tau_S^{-1}$ was obtained by applying the primary mode method to the primary expression. The recombination lifetime (Example A in Table 1) obtained as the reciprocal of the time constant $\tau_b^{-1}+\tau_S^{-1}$ was a value shown in Table 1.

Table 1 also shows the recombination lifetimes obtained by applying the primary mode method described in the SEMI standard and the 1/e method described in the SEMI standard to the decay curve illustrated in the left figure of Fig. 4.

[Table 1]

| | |
|---|---|
| Primary mode method | 3453.1 μsec |
| 1/e lifetime method | 3510.5 μsec |
| Example A | 6323.3 μsec |

From the results shown in Table 1, it can be confirmed that the recombination lifetime value is underestimated to about 60% thereof in the conventional primary mode method and 1/e lifetime method compared to Example A.

Next, it was confirmed that the function of Expression (1) is a function of time close to the actually measured decay, in accordance with the following method.

First, in order to determine the remaining undetermined parameter constants A and C in Expression (1), fitting was performed as follows.

Using the time constant $\tau_b^{-1}+\tau_S^{-1}$ obtained in the above-mentioned example, Expression (1) has a form of a linear expression with respect to $\exp[-(\tau_b^{-1}+\tau_S^{-1})t]$. That is, in the sampling region determined by autoscaling, the decay curve can be linearly approximated with respect to $\exp[-(\tau_b^{-1}+\tau_S^{-1})t]$ as shown in the left figure of Fig. 5. As a result, the constants A and C can be obtained as the slope and intercept.

When Expression (1) is applied using the time constant $\tau_b^{-1}+\tau_S^{-1}$ and the constants A and C obtained in such a manner, as shown in the right figure of Fig. 5, a fitting curve (new method fitting in the right figure of Fig. 5), which is appropriate for a wider range of the decay curve, is obtained compared to a case of performing fitting in accordance with the primary mode method or the 1/e lifetime method (primary mode lifetime fitting and 1/e lifetime fitting in the right figure of Fig. 5).

From the above-mentioned results, it can be confirmed that the function of Expression (1) is a function of time close to the actually measured decay.

Figs. 6 and 7 illustrate comparison results between an example of a semiconductor sample evaluation method according to an aspect of the present invention (new method) and the conventional method.

A left figure of Fig. 6 illustrates recombination lifetime values, which are obtained through the same method as in Example A (in Fig. 6, new method), and recombination lifetime values, which are obtained through the conventional primary mode method (in Fig. 6, "conventional method"), for a plurality of n-type silicon wafers for which a recombination lifetime value of about 7000 μsec was obtained through the same method as in above-mentioned Example A. A right figure of Fig. 6 illustrates a CV value (standard deviation / arithmetic mean × 100, unit: %) of the measurement results illustrated in the left figure of Fig. 6. From the results illustrated in Fig. 6, it can be confirmed that, in the new method, the variation in the recombination lifetime value is suppressed compared to the conventional method.

Fig. 7 illustrates fitting curves, which are obtained by fitting the decay curves obtained through measurement according to the μ-PCD method through Expression (1) as described above, and fitting curves, which are obtained by fitting the decay curves in accordance with the conventional primary mode method, for Sample ① having a largest difference in the positive direction and Sample ② having a largest difference in the negative direction in the conventional method in Fig. 6. Fig. 7 also illustrates the recombination lifetime values of the respective samples obtained by the new method and the conventional method. From the results illustrated in Fig. 7, it can also be confirmed that the function of Expression (1) is a function of time close to the actually measured decay.

<Derivation of Surface Recombination Lifetime $\tau_s$, SRH Recombination Lifetime $\tau_b$, and Surface Recombination Rate $S_r$>

As a result of the intensive study of the present inventors on the derivation of the surface recombination lifetime $\tau_s$, the constant term C in Expression (10)' can be represented by Expression (11) when the Poisson equation is applied to the charge distribution near the surface of the semiconductor sample (relationship between the carrier concentration and the surface charge density). It is seen from Expression (11) that the constant term is a quadratic expression of a surface charge density $Q_s$. Therefore, it was newly found that the constant term can be analyzed using a quadratic function.

$$C = (\tau_{eff}/\tau_s)/(2kT\varepsilon_s\varepsilon_0)\times Q_s^2+\tau_{eff}/\tau_s\times n_0\text{: ... (11)}$$

In Expression (11), k is a Boltzmann constant [eV/K], T is an absolute temperature [K], $\varepsilon_s$ is a dielectric constant of the semiconductor sample [F/m], $\varepsilon_0$ is a dielectric constant of vacuum [F/m], $Q_s$ is a surface charge density [F/m$^2$], and $n_0$ is an equilibrium carrier concentration [cm$^{-3}$].

As described above, $\tau_{eff}$ in Expression (11) can be derived by performing fitting calculations using Expression (10)' on the decay curve obtained by performing measurement according to the photoconductive decay method on the semiconductor sample.

Next, Fig. 8 is a schematic diagram of a plot for deriving the surface recombination lifetime $\tau_s$. In order to derive $\tau_s$, the decay curve is acquired a plurality of times by performing measurement on the semiconductor sample which is an evaluation target in accordance with the photoconductive decay method while changing the surface charge density. When the constant term C calculated using Expression (10)' with respect to the surface charge density Qs is plotted for the decay signals obtained in such a manner for each different surface charge density, the constant term C is a quadratic function as shown in Expression (11) (refer to Fig. 8). The minimum value $C_{min}$ of the quadratic function illustrated in Fig. 8 is represented by Expression (11)' below, which shows the 2$^{nd}$ term "$\tau_{eff}/\tau_s x n_0$" of Expression (11) in the equilibrium state.

$$C_{min} = \tau_{eff}/\tau_s\times n_0\text{: ... (11)'}$$

Therefore, the surface recombination lifetime $\tau_S$ can be calculated by substituting the minimum value $C_{min}$ of the quadratic function, the equilibrium carrier concentration $n_0$, and $\tau_{eff}$ into Expression (11)'. However, in the $\mu$-PCD method, the microwave reflectance signal intensity is measured in voltage, and the unit of C is voltage. Therefore, a relationship between a reflectance signal intensity and a carrier concentration is converted using an amount of carriers injected by light pulses and an initial reflectance signal intensity of microwaves. The equilibrium carrier concentration $n_0$ is the equilibrium carrier concentration of the semiconductor sample which is a measurement target.

The minimum value $C_{min}$ of the 2nd term "$\tau_{eff}/\tau_s \times n_0$" in Expression (11) can be obtained as the minimum value of the vertical axis y in a quadratic function (quadratic curve). The quadratic function is obtained, as illustrated in Fig. 8, for example, by plotting measurement points on a graph in which the vertical axis (y axis) represents C and the horizontal axis (x axis) represents the surface charge density and performing fitting processing on the plots through a well-known method such as the least squares method.

In the example illustrated in Fig. 8, the vertical axis (y axis) represents the absolute value of the constant term C, and the horizontal axis (x axis) represents the surface charge density. However, a variable x on the horizontal axis is not limited to a value of the surface charge density itself. For example, the surface charge density can be changed by the number of corona charging treatments (that is, the number of corona charges). In a case where the surface charge density is changed by the number of corona charges, the number of corona charges can be employed as the variable x on the horizontal axis. For example, the variable x on the horizontal axis the number of corona charges to which positive charge is applied can be employed as a positive value (for example, x = 1 if the number is 1), and the number of corona charges to which negative charge is applied can be employed as a negative value (for example, x = -1 if the number is 1). The variable y on the horizontal axis is not limited to the absolute value of the constant term C. For example, the value of the constant term C itself can be employed as the variable y on the vertical axis.

That is, by performing the fitting processing a plot in a well-known method in which a surface charge density related value is employed as the variable x, and a value relating to the constant term is employed as the variable y, a quadratic function of $y = ax^2+bx+c$ is obtained. a is a positive constant, and b and c are positive or negative constants or zero. The minimum value of y in the quadratic function can be used as $C_{min}$ in Expression (11). Then, the surface recombination lifetime $\tau_s$, can be obtained from Expression (11)'.

Furthermore, the SRH recombination lifetime (bulk lifetime) $\tau_b$ can be calculated by substituting $\tau_{eff}$ and $\tau_S$ into Expression (1)'.

$$1/\tau_{eff} = 1/\tau_b+1/\tau_s \ ... \ (1)'$$

Further, the surface recombination rate $S_r$ can be obtained from the thickness d of the semiconductor sample and the surface recombination lifetime $\tau_S$ through Expression (12) below.

$$S_r = d/(2\tau_S) \ ... \ (12)$$

[Semiconductor Sample Evaluation Device]

An aspect of the present invention relates to a semiconductor sample evaluation device that performs the above-mentioned evaluation method. The evaluation device includes a measurement unit and a processing unit. The measurement unit performs measurement on the semiconductor sample which is an evaluation target through the photoconductive decay method. The processing unit performs signal data processing, which uses a model expression including the exponential decay term and the constant term on the decay curve, and obtains the quadratic function.

The measurement unit performs measurement on the semiconductor sample which is a measurement target through the photoconductive decay method. The measurement unit is able to change the light pulse intensity. This point is as described above. Further, in an embodiment, the measurement unit can include a corona charging treatment unit in order to change the surface charge density. Details of the measurement unit are as described above. In addition, as described above for the PCD device, the measurement unit may include the surface charge density related value measurement device.

To perform the semiconductor sample evaluation method according to an aspect of the present invention, the processing unit of the evaluation device performs signal data processing, which uses a model expression including an exponential decay term and a constant term, on the decay curve, and obtains the quadratic function. The processing unit can be configured using a well-known analysis program.

Further, the processing unit performs the signal data processing on the decay curve using the model expression including the exponential decay term and the constant term. Thereby, the processing unit acquires the exponential decay expression by canceling out the constant term in the model expression. As a result, it is possible to obtain the time constant $\tau_b^{-1}+\tau_S^{-1}$ from the exponential decay expression.

The signal data processing may include repeating an operation of sampling a time-series signal modeled by the model expression and taking a difference.

Furthermore, the processing unit is able to perform autoscaling to determine a sampling region in which the sampling is performed. The processing unit is able to determine, as the sampling region, a region which is less affected by recombination and less affected by noise through the autoscaling. Such autoscaling is as described above.

In the evaluation device, the measurement unit or a calculation unit provided separately from the measurement unit is able to derive the recombination lifetime $\tau_{eff}$ of the semiconductor sample from the exponential decay expression obtained through the signal data processing. The measurement unit or the calculation unit provided separately from the measurement unit is also able to derive the surface recombination lifetime $\tau_s$, the SRH recombination lifetime $\tau_b$, and the surface recombination rate $S_r$ after determining the quadratic function. Such derivation can be performed using a well-known analysis program provided in the measurement unit or calculation unit.

In an embodiment, in the evaluation device, a PCD measurement device having a measurement unit that performs measurement through the PCD method may further include the processing unit and/or the calculation unit. In another embodiment, further, one or more computers other than the PCD measurement device having the measurement unit that performs measurement through the PCD method include the processing unit and/or the calculation unit. With such a configuration, various information such as measurement results, processing results, and calculation results can be transmitted and received by wired or wireless communication between such a computer and the PCD measurement device, or between a plurality of computers. One computer may include the processing unit and the calculation unit, and different computers may respectively include the processing unit and the calculation unit.

[Semiconductor Wafer Manufacturing Method]

An aspect of the present invention relates to
a semiconductor wafer manufacturing method (hereinafter also referred to as a "manufacturing method 1") including:

manufacturing a semiconductor wafer lot including a plurality of semiconductor wafers;
extracting at least one semiconductor wafer from the semiconductor wafer lot;
evaluating the extracted semiconductor wafer by the above-mentioned evaluation method; and
providing a semiconductor wafer, which has the same semiconductor wafer lot as a semiconductor wafer determined to be a non-defective product as a result of the evaluating, for shipment as a product semiconductor wafer.

Further, an aspect of the present invention relates to
a semiconductor wafer manufacturing method (hereinafter also referred to as a "manufacturing method 2") including:

manufacturing an evaluation semiconductor wafer under a test manufacturing condition;
evaluating the manufactured evaluation semiconductor wafer through the above-mentioned semiconductor sample evaluation method;
determining a manufacturing condition, which is obtained by modifying the test manufacturing condition, as an actual manufacturing condition on the basis of a result of the evaluating, or determining the test manufacturing condition as an actual manufacturing condition; and
manufacturing a semiconductor wafer under the determined actual manufacturing condition.

In the manufacturing method 1, a semiconductor wafer from the same lot as a semiconductor wafer determined to be non-defective product as a result of so-called sampling test is provided for shipment as a product semiconductor wafer. In contrast, in the manufacturing method 2, a semiconductor wafer manufactured under test manufacturing conditions is evaluated, and actual manufacturing conditions are determined on the basis of the evaluation results. In both manufacturing methods 1 and 2, the semiconductor wafer is evaluated by the evaluation method according to the aspect of the present invention described above.

In the manufacturing method 1, the semiconductor wafer lot can be manufactured in the same manner as in the manufacturing method of the general semiconductor wafer. For example, an example of a silicon wafer, which is one embodiment of the semiconductor wafer, may be a polished wafer. The polished wafer can be manufactured by a manufacturing process, which includes cutting (slicing) a silicon wafer from a silicon single crystal ingot grown by a Czochralski method (CZ method) or the like, chamfering, rough polishing (for example, lapping), etching, mirror polishing (finish polishing), and cleaning performed between the above-mentioned work processes or after the work process. Further, an annealed wafer can be manufactured by performing a heat treatment, more specifically, an annealing treatment on the polished wafer manufactured as described above. An epitaxial wafer can be manufactured by vapor-phase growth (epitaxial growth) of an epitaxial layer on a surface of the polished wafer manufactured as described above.

The total number of semiconductor wafers included in a semiconductor wafer lot is not particularly limited. The number of semiconductor wafers extracted from a manufactured semiconductor wafer lot and subjected to so-called sampling test is at least one, and may be two or more. The number is not particularly limited.

The semiconductor wafer extracted from the semiconductor wafer lot is evaluated through an evaluation method according to an aspect of the present invention. For example, the recombination lifetime value obtained by such evaluation can be used as an index to determine whether or not the evaluated semiconductor wafer is defective. For example, the greater the amount of metal contamination, the shorter the recombination lifetime $\tau_{eff}$ measured through the PCD method. Therefore, the presence or absence of metal contamination in the semiconductor wafer and/or the degree of metal contamination can be evaluated, on the basis of the value of the recombination lifetime measured through the PCD method. Therefore, for example, the value of the recombination lifetime $_{eff}$ being equal to or greater than a predetermined threshold value or being greater than the threshold value can be set as a criterion for determining whether or not the product wafer is defective. Such a threshold value may be set in accordance with the quality required for the product wafer. The semiconductor wafers of the same semiconductor wafer lot as the semiconductor wafers determined to be a non-defective product can be provided (for example, packed, and so on) for shipment as product semiconductor wafers.

Regarding the manufacturing method 2, the test manufacturing condition and the actual manufacturing condition can be various conditions in various processes for manufacturing a semiconductor wafer. The various processes for manufacturing a semiconductor wafer are the same as the processes of the manufacturing method 1 as described above. The "actual manufacturing condition" refer to the manufacturing condition for the product semiconductor wafer.

In the manufacturing method 2, as a preliminary stage for determining the actual manufacturing condition, the test manufacturing condition is set, and an evaluation semiconductor wafer is manufactured under the test manufacturing condition. The manufactured semiconductor wafer is evaluated through an evaluation method according to an aspect of the present invention. Using the value of the recombination lifetime $_{eff}$ obtained by such evaluation as an index, it can be determined whether the test manufacturing condition is the condition employed as the actual manufacturing condition, or whether the manufacturing condition obtained by modifying the test manufacturing condition should be employed as the actual manufacturing condition. For example, from a viewpoint the same as that described above for the manufacturing method 1, the obtained value of the recombination lifetime $_{eff}$ being equal to or greater than a predetermined threshold value or being greater than the threshold value can be set as a criterion for determining whether the test manufacturing conditions are conditions employed as the actual manufacturing conditions. Examples of the manufacturing conditions modified as a result of the determination include manufacturing conditions that may cause metal contamination. One example thereof is modification of the heat treatment furnace used (for example, replacement of parts, cleaning of parts, cleaning of the inside of the furnace, and the like).

The well-known techniques relating to manufacturing methods of semiconductor wafers can be applied to other details of manufacturing method 1 and manufacturing method 2. According to manufacturing method 1 and manufacturing method 2, for example, the market can be stably supplied with semiconductor wafers with less metal contamination.

Examples

Hereinafter, the present invention will be further described on the basis of Examples. However, the present invention is not limited to the embodiments shown in Examples.

[Example 1]

$\mu$PCD measurements were performed on the n-type silicon wafer (single crystal silicon wafers) by changing the number of corona charges. The number of corona charges to apply positive charges was 1, 3, or 5, and the number of corona charges to apply negative charges was 1, 3, or 5. The charge amount (absolute value) was the same for each charge. The number of corona charges was employed as a surface charge density related value, which is a variable x. The number of corona charges to which positive charge is applied was employed as a positive value, and the number of corona charges to which negative charge is applied was employed as a negative value. The absolute value of the constant term C obtained from the fitting calculation of the decay curve obtained from each measurement was employed as variable y.

A decay curve obtained from a measurement with 0 corona charges was selected from the plurality of decay curves obtained from a plurality of measurements. Fitting calculation was performed using Expression (10)' in the same manner as described above in Example A. As a result, $\tau_{eff}$ was calculated to be 5300 $\mu$s.

The constant term C was calculated from the fitting calculation results for each of the plurality of decay curves obtained from the plurality of measurements.

The above-mentioned values were plotted by being employed as values on the horizontal axis (x-axis) and vertical axis (y-axis). The surface recombination lifetime $\tau_S$ was calculated to be 115000 $\mu$s ($n_0$ is 5 mV in the present example), from the minimum value on the vertical axis (the minimum value calculated by performing fitting of a quadratic function on an average of the values obtained by performing measurements at 50 points on the surface each time) and Expression (11)' (the 2$^{nd}$ term of Expression (11) "$\tau_{eff}/\tau_s \times n_0$").

Furthermore, from Expression (1)', the SRH recombination lifetime (bulk lifetime) $\tau_b$ was calculated to be 5560 $\mu$s.

Table 2 shows the above-mentioned calculation results, and Fig. 9 illustrates the quadratic curve obtained in Example 1.

[Table 2]

| $\tau_{eff}$($\mu$s) | $\tau_s$($\mu$s) | $\tau_b$($\mu$s) |
|---|---|---|
| 5300 | 115000 | 5560 |

Furthermore, the surface recombination rate $S_r$ of the above-mentioned silicon wafer was calculated from the thickness d of the above-mentioned silicon wafer and the surface recombination lifetime $\tau_S$ using Expression (12), and was 0.34 cm/s.

[Example 2]

An example using a $\mu$PCD device equipped with a corona charging treatment unit and a non-contact CV device will be described.

First, corona charging treatment was performed on an n-type silicon wafer (single crystal silicon wafer).

Next, the amount of surface charge on the wafer surface was actually measured using a non-contact CV device, the surface charge density was calculated, and then the $\mu$PCD measurement was performed.

Such a series of treatments, measurements, and calculations was performed with different numbers of corona charges and different positive and negative charges.

A decay curve obtained from a measurement with 0 corona charges was selected from the plurality of decay curves obtained from a plurality of measurements. Fitting calculation was performed using Expression (10)' in the same manner as described above in Example A. As a result, $\tau_{eff}$ was calculated to be 5300 $\mu$s.

Regarding the measurement results obtained from a plurality of measurements, the surface charge density was plotted on the horizontal axis and the absolute value of the constant term was plotted on the vertical axis. The surface recombination lifetime $\tau_S$ was calculated to be 121000 $\mu$s ($n_0$ is 5 mV in the present example), from the minimum value on the vertical axis (the minimum value calculated by performing fitting of a quadratic function on an average value of the values obtained by performing measurements at 50 points on the surface each time) and Expression (11)' (the 2$^{nd}$ term of Expression (11) "$\tau_{eff}/\tau_s \times n_0$").

Furthermore, from Expression (1)', the SRH recombination lifetime (bulk lifetime) $\tau_b$ was calculated to be 5540 $\mu$s.

The above-mentioned calculation results are shown in Table 3, and the quadratic curve obtained in Example 2 is illustrated in Fig. 10.

[Table 3]

| $\tau_{eff}$($\mu$s) | $\tau_s$($\mu$s) | $\tau_b$($\mu$s) |
|---|---|---|
| 5300 | 121000 | 5540 |

Furthermore, the surface recombination rate $S_r$ of the above-mentioned silicon wafer was calculated from the thickness d of the above-mentioned silicon wafer and the surface recombination lifetime $\tau_S$ using Expression (12), and was 0.32 cm/s.

Industrial Applicability

An aspect of the present invention is useful in the technical fields of various semiconductor wafers.

## Claims

**1.** A semiconductor sample evaluation method comprising:

acquiring, a plurality of times, a decay curve by performing measurement on a semiconductor sample which is an evaluation target in accordance with a photoconductive decay method while changing a surface charge density;

performing signal data processing using a model expression including an exponential decay term and a constant term on at least one decay curve among decay curves obtained through the plurality of measurements;
obtaining a recombination lifetime $\tau_{eff}$ of the semiconductor sample from an exponential decay expression obtained through the signal data processing;
obtaining a quadratic function, in which a surface charge density related value is represented by a variable x and a value related to the constant term is represented by a variable y, from measurement results obtained through the plurality of measurements; and
obtaining a surface recombination lifetime $\tau_s$ of the semiconductor sample from the quadratic function.

**2.** The semiconductor sample evaluation method according to claim 1,

wherein the surface recombination lifetime $\tau_s$ is calculated from Expression (11)' below represented by

$$C_{min} = \tau_{eff}/\tau_s \times n_0: \ldots (11)',$$

(in Expression (11)', $n_0$ is an equilibrium carrier concentration),
where $C_{min}$ is a minimum value of y in the quadratic function.

**3.** The semiconductor sample evaluation method according to claim 1, further comprising:
obtaining an SRH recombination lifetime $\tau_b$ of the semiconductor sample from the recombination lifetime $\tau_{eff}$ and the surface recombination lifetime $\tau_s$.

**4.** The semiconductor sample evaluation method according to claim 3,
wherein the SRH recombination lifetime $\tau_b$ is obtained from Expression (1)' below represented by

$$1/\tau_{eff} = 1/\tau_b + 1/\tau_s \ldots (1)'.$$

**5.** The semiconductor sample evaluation method according to claim 1, further comprising:
obtaining a surface recombination rate $S_r$ of the semiconductor sample from a thickness d of the semiconductor sample and the surface recombination lifetime $\tau_S$ through Expression (12) below represented by

$$S_r = d/(2\tau_S) \ldots (12).$$

**6.** The semiconductor sample evaluation method according to claim 1, further comprising:

acquiring the exponential decay expression by performing the signal data processing to cancel out the constant term in the model expression; and
obtaining a time constant $\tau_b^{-1}+\tau_S^{-1}$ from the exponential decay expression,
wherein $\tau_b$ is an SRH recombination lifetime, and $\tau_S$ is the surface recombination lifetime.

**7.** The semiconductor sample evaluation method according to claim 6,
wherein the signal data processing comprises repeating an operation of sampling a time-series signal modeled by the model expression and taking a difference.

**8.** The semiconductor sample evaluation method according to claim 7, further comprising:
performing autoscaling to determine a sampling region in which the sampling is performed.

**9.** The semiconductor sample evaluation method according to claim 8,
wherein the autoscaling determines a region, which is less affected by Auger recombination and less affected by noise, as the sampling region.

**10.** The semiconductor sample evaluation method according to claim 1,

wherein the model expression is Expression (10)' below represented by

$$xi(ti) = A \times \exp[-(\tau_b^{-1}+\tau_S^{-1})ti]-C \ ... \ (10)'$$

(in Expression (10)', ti is a time elapsed after irradiation with excitation light, xi(ti) is a signal intensity at the elapsed time ti, $\tau_b$ is an SRH recombination lifetime, $\tau_S$ is the surface recombination lifetime, and A and C are constants).

**11.** The semiconductor sample evaluation method according to claim 1, further comprising:

calculating the surface recombination lifetime $\tau_s$ from Expression (11)' below represented by

$$C_{min} = \tau_{eff}/\tau_s \times n_0: \ ... \ (11)'$$

(in Expression (11)', $n_0$ is an equilibrium carrier concentration),
where $C_{min}$ is a minimum value of y in the quadratic function;
obtaining an SRH recombination lifetime $\tau_b$ of the semiconductor sample from the recombination lifetime $\tau_{eff}$ and the surface recombination lifetime $\tau_s$;
obtaining the SRH recombination lifetime $\tau_b$ from Expression (1)' below represented by

$$1/\tau_{eff} = 1/\tau_b+1/\tau_s \ ... \ (1)';$$

acquiring the exponential decay expression by performing the signal data processing to cancel out the constant term in the model expression; and
obtaining the time constant $\tau_b^{-1}+\tau_S^{-1}$ from the exponential decay expression,
wherein $\tau_b$ is the SRH recombination lifetime, and $\tau_S$ is the surface recombination lifetime,
the signal data processing includes repeating an operation of sampling a time-series signal modeled by the model expression and taking a difference,
the signal data processing further includes performing autoscaling to determine a sampling region in which sampling is performed,
the autoscaling determines a region, which is less affected by Auger recombination and less affected by noise, as the sampling region, and
the model expression is Expression (10)' below represented by

$$xi(ti) = A \times \exp[-(\tau_b^{-1}+\tau_S^{-1})ti]-C \ ... \ (10)'$$

(in Expression (10)', ti is a time elapsed after irradiation with excitation light, xi(ti) is a signal intensity at the elapsed time ti, $\tau_b$ is an SRH recombination lifetime, $\tau_S$ is the surface recombination lifetime, and A and C are constants).

**12.** The semiconductor sample evaluation method according to claim 1, further comprising:

calculating the surface recombination lifetime $\tau_s$ from Expression (11)' below represented by

$$C_{min} = \tau_{eff}/\tau_s \times n_0: \ ... \ (11)'$$

(in Expression (11)', $n_0$ is an equilibrium carrier concentration),
where $C_{min}$ is a minimum value of y in the quadratic function;
obtaining a surface recombination rate $S_r$ of the semiconductor sample from a thickness d of the semiconductor sample and the surface recombination lifetime $\tau_S$ through Expression (12) below represented by

$$S_r = d/(2\tau_S) \ ... \ (12);$$

acquiring the exponential decay expression by performing the signal data processing to cancel out the constant term in the model expression; and
obtaining the time constant $\tau_b^{-1}+\tau_S^{-1}$ from the exponential decay expression,
wherein $\tau_b$ is the SRH recombination lifetime, and $\tau_S$ is the surface recombination lifetime,
the signal data processing includes repeating an operation of sampling a time-series signal modeled by the model expression and taking a difference,

the signal data processing further includes performing autoscaling to determine a sampling region in which sampling is performed,
the autoscaling determines a region, which is less affected by Auger recombination and less affected by noise, as the sampling region, and
the model expression is Expression (10)' below represented by

$$xi(ti) = A\times\exp[-(\tau_b^{-1}+\tau_S^{-1})ti]-C \quad ... (10)'$$

(in Expression (10)', ti is a time elapsed after irradiation with excitation light, xi(ti) is a signal intensity at the elapsed time ti, $\tau_b$ is an SRH recombination lifetime, $\tau_S$ is the surface recombination lifetime, and A and C are constants).

**13.** A semiconductor sample evaluation device,

which performs the semiconductor sample evaluation method according to any one of claims 1 to 12,
the evaluation device comprising:
a measurement unit that performs measurement on a semiconductor sample which is an evaluation target in accordance with a photoconductive decay method; and
a processing unit that performs signal data processing, which uses a model expression including an exponential decay term and a constant term, on the decay curve, and obtains the quadratic function.

**14.** The evaluation device according to claim 13,
wherein a light pulse intensity of the measurement unit is variable.

**15.** The evaluation device according to claim 13,
wherein the measurement unit further comprises a corona charging treatment unit.

**16.** The evaluation device according to claim 13,
wherein the measurement unit further comprises a surface charge density related value measurement unit that measures a surface charge density related value of the semiconductor sample to be subjected to the measurement.

**17.** The evaluation device according to claim 13,

wherein a light pulse intensity of the measurement unit is variable, and
the measurement unit further comprise a corona charging treatment unit and a surface charge density related value measurement unit that measures a surface charge density related value of the semiconductor sample to be subjected to the measurement.

**18.** A semiconductor wafer manufacturing method comprising:

manufacturing a semiconductor wafer lot including a plurality of semiconductor wafers;
extracting at least one semiconductor wafer from the semiconductor wafer lot;
evaluating the extracted semiconductor wafer by the evaluation method according to any one of claims 1 to 12; and
providing a semiconductor wafer, which has the same semiconductor wafer lot as a semiconductor wafer determined to be a non-defective product as a result of the evaluating, for shipment as a product semiconductor wafer.

**19.** A semiconductor wafer manufacturing method comprising:

manufacturing an evaluation semiconductor wafer under a test manufacturing condition;
evaluating the manufactured evaluation semiconductor wafer through the semiconductor sample evaluation method according to any one of claims 1 to 12;
determining a manufacturing condition, which is obtained by modifying the test manufacturing condition, as an actual manufacturing condition on the basis of a result of the evaluating, or determining the test manufacturing condition as an actual manufacturing condition; and
manufacturing a semiconductor wafer under the determined actual manufacturing condition.

Fig. 1

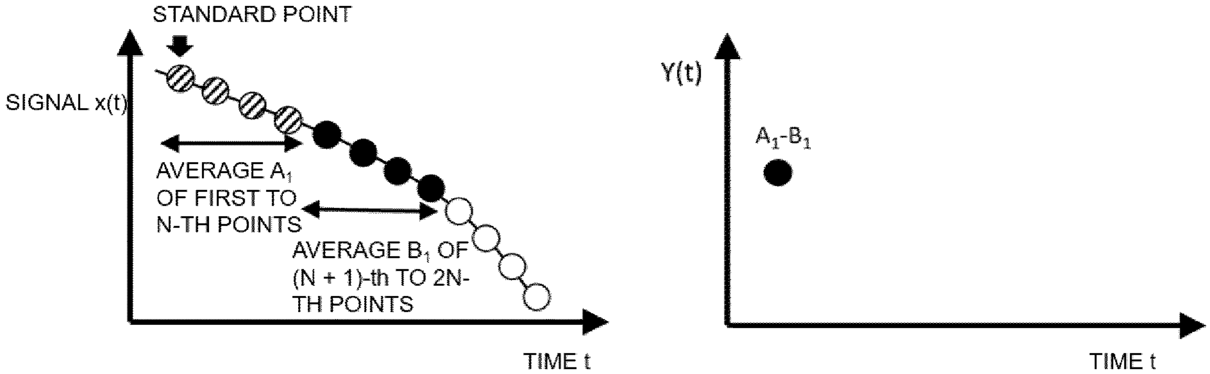


Fig. 2

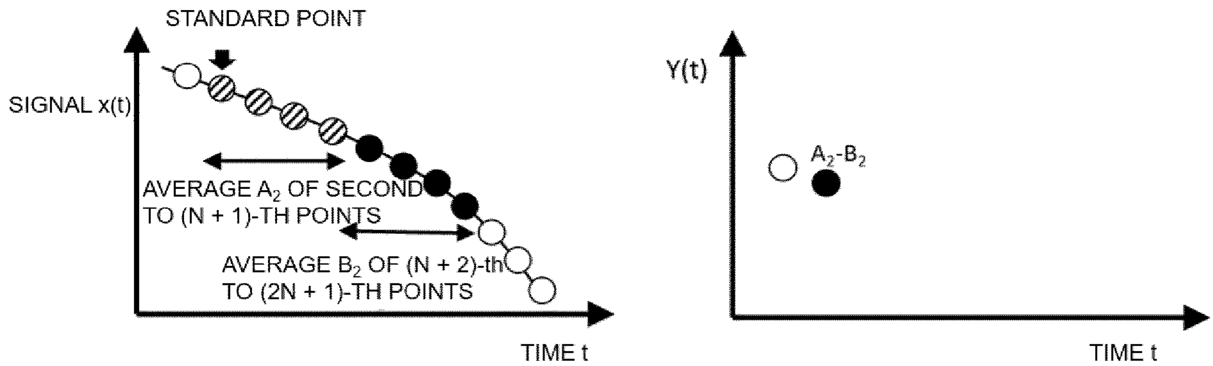


Fig. 3

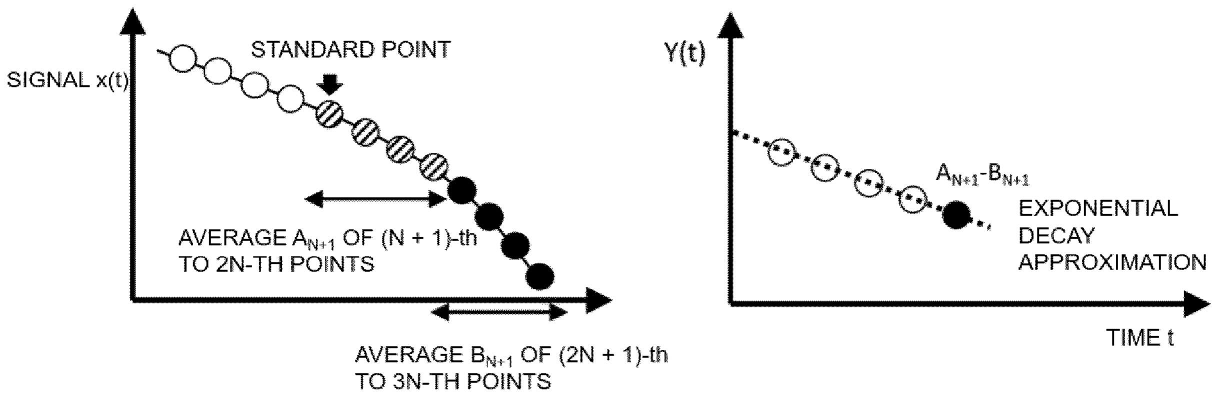

Fig. 4

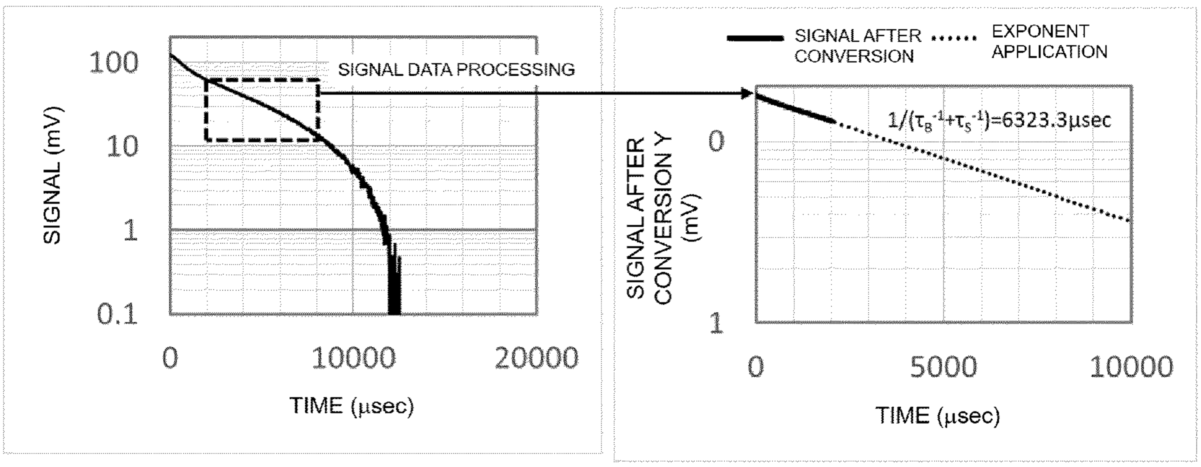
100
10
1
0.1
SIGNAL (mV)
SIGNAL DATA PROCESSING
0
10000
20000
TIME (µsec)
SIGNAL AFTER CONVERSION
EXPONENT APPLICATION
$1/(\tau_B^{-1}+\tau_S^{-1})$=6323.3µsec
0
1
SIGNAL AFTER CONVERSION Y (mV)
0
5000
10000
TIME (µsec)

Fig. 5

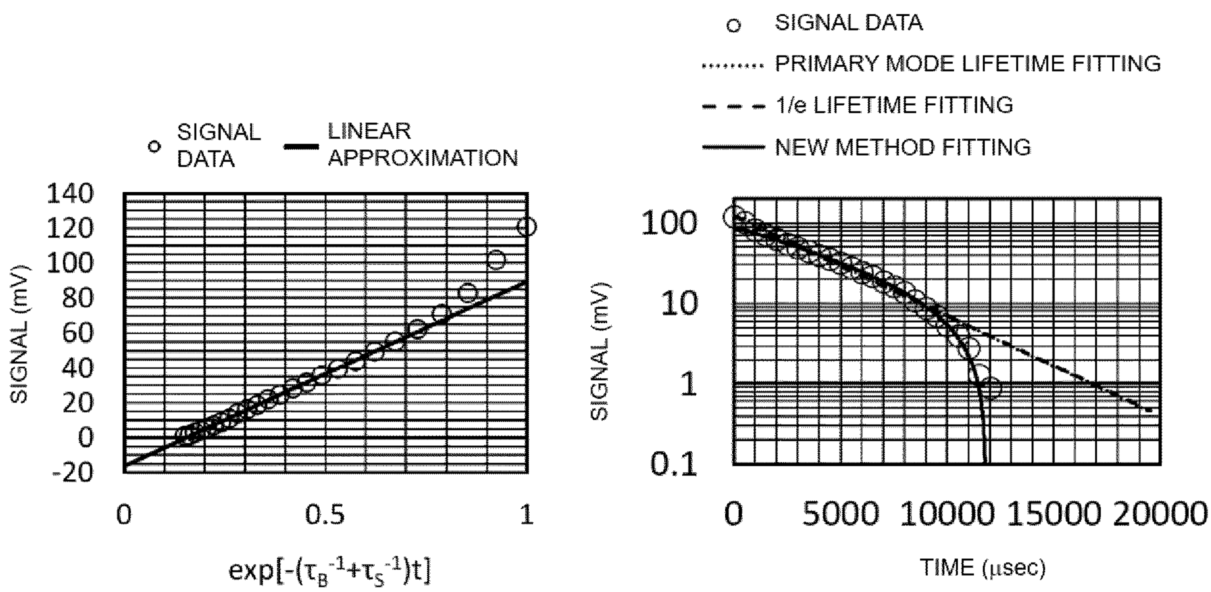
SIGNAL DATA
LINEAR APPROXIMATION
140
120
100
80
60
40
20
0
-20
SIGNAL (mV)
0
0.5
1
$\exp[-(\tau_B^{-1}+\tau_S^{-1})t]$
SIGNAL DATA
PRIMARY MODE LIFETIME FITTING
1/e LIFETIME FITTING
NEW METHOD FITTING
100
10
1
0.1
SIGNAL (mV)
0
5000
10000
15000
20000
TIME (µsec)

Fig. 6

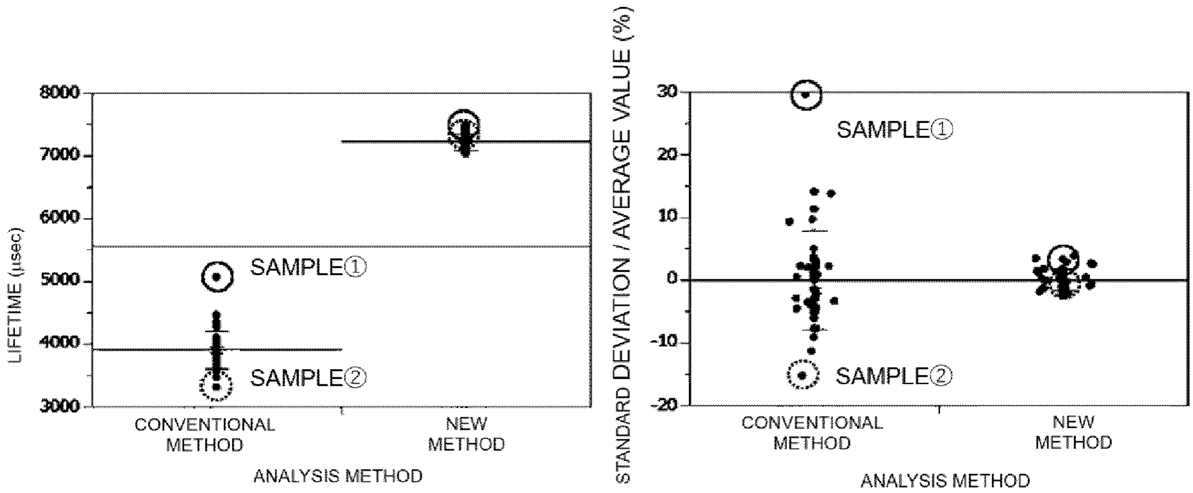
LIFETIME (μsec)
8000
7000
6000
5000
4000
3000
SAMPLE①
SAMPLE②
CONVENTIONAL METHOD
NEW METHOD
ANALYSIS METHOD
STANDARD DEVIATION / AVERAGE VALUE (%)
30
20
10
0
-10
-20
SAMPLE①
SAMPLE②
CONVENTIONAL METHOD
NEW METHOD
ANALYSIS METHOD

Fig. 7

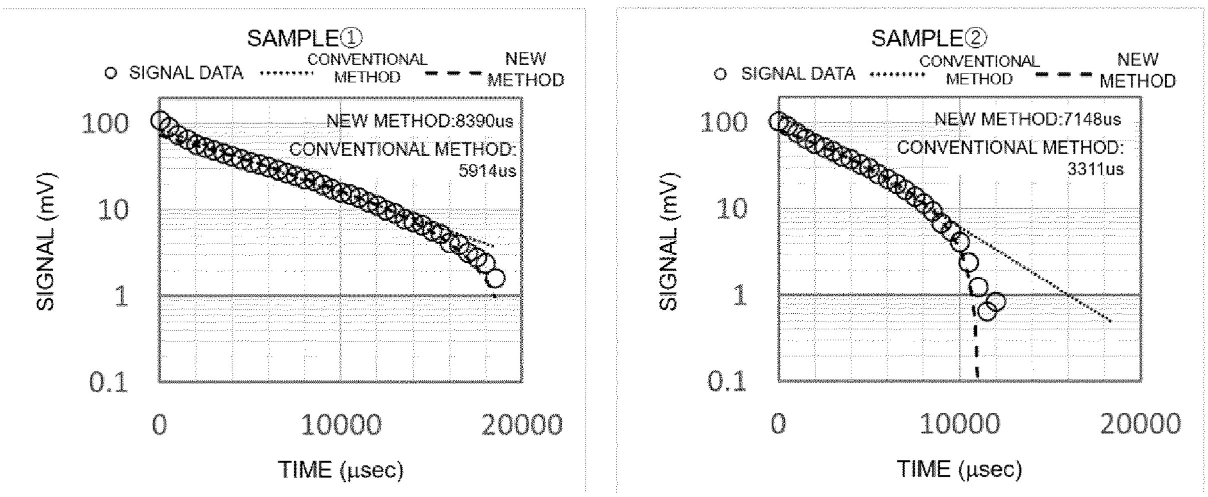
SAMPLE①
SIGNAL DATA
CONVENTIONAL METHOD
NEW METHOD
NEW METHOD:8390us
CONVENTIONAL METHOD: 5914us
SIGNAL (mV)
100
10
1
0.1
0
10000
20000
TIME (μsec)
SAMPLE②
SIGNAL DATA
CONVENTIONAL METHOD
NEW METHOD
NEW METHOD:7148us
CONVENTIONAL METHOD: 3311us
SIGNAL (mV)
100
10
1
0.1
0
10000
20000
TIME (μsec)

Fig. 8

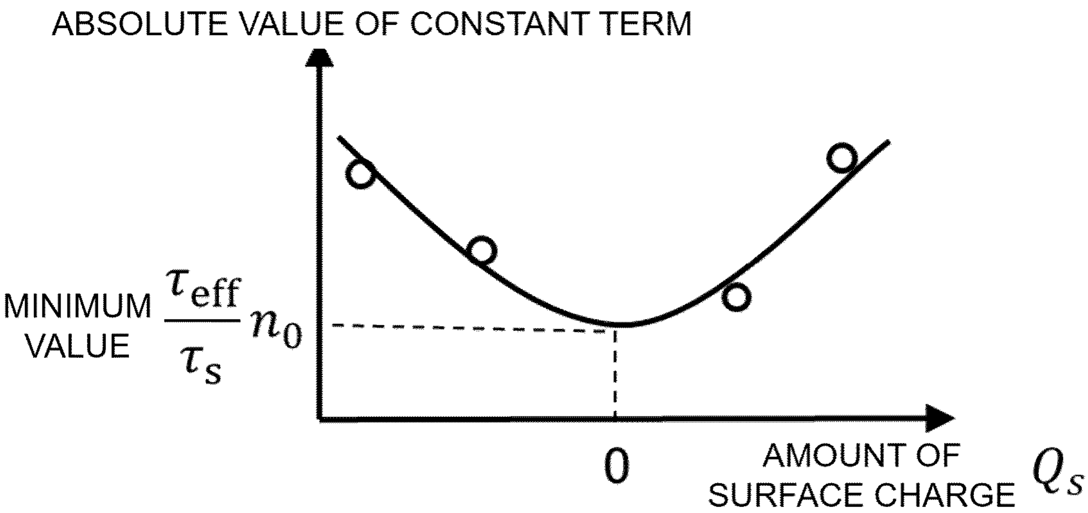
ABSOLUTE VALUE OF CONSTANT TERM
MINIMUM VALUE $\frac{\tau_{eff}}{\tau_s} n_0$
0
AMOUNT OF SURFACE CHARGE $Q_s$

Fig. 9

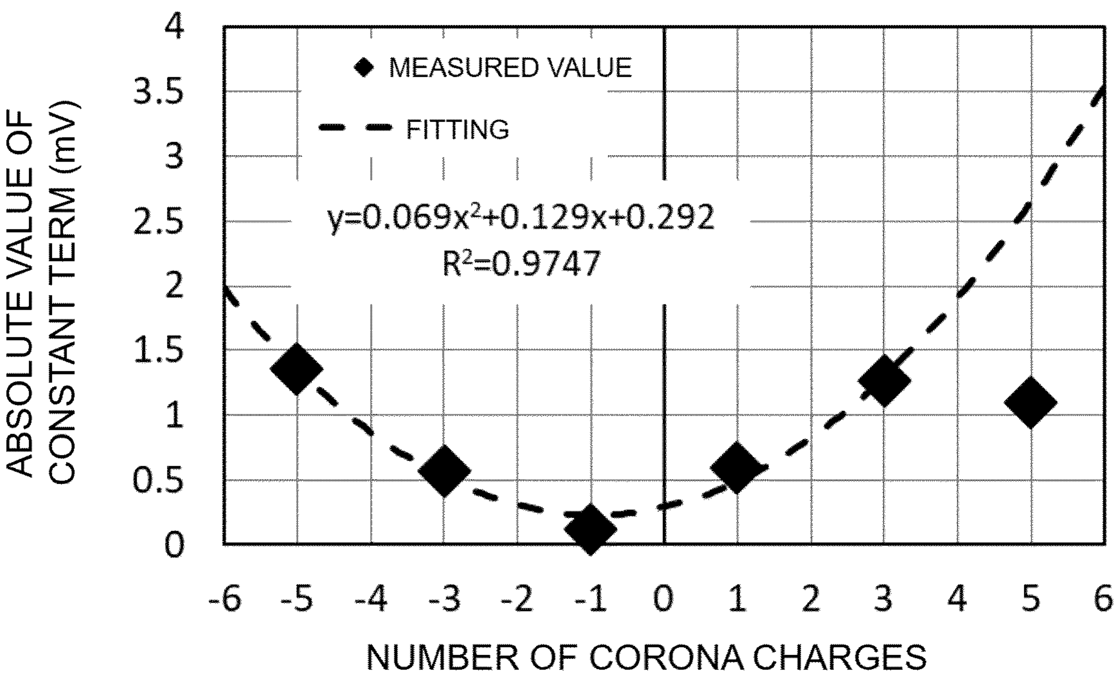
ABSOLUTE VALUE OF CONSTANT TERM (mV)
4
3.5
3
2.5
2
1.5
1
0.5
0
MEASURED VALUE
FITTING
$y=0.069x^2+0.129x+0.292$
$R^2=0.9747$
-6 -5 -4 -3 -2 -1 0 1 2 3 4 5 6
NUMBER OF CORONA CHARGES

Fig. 10

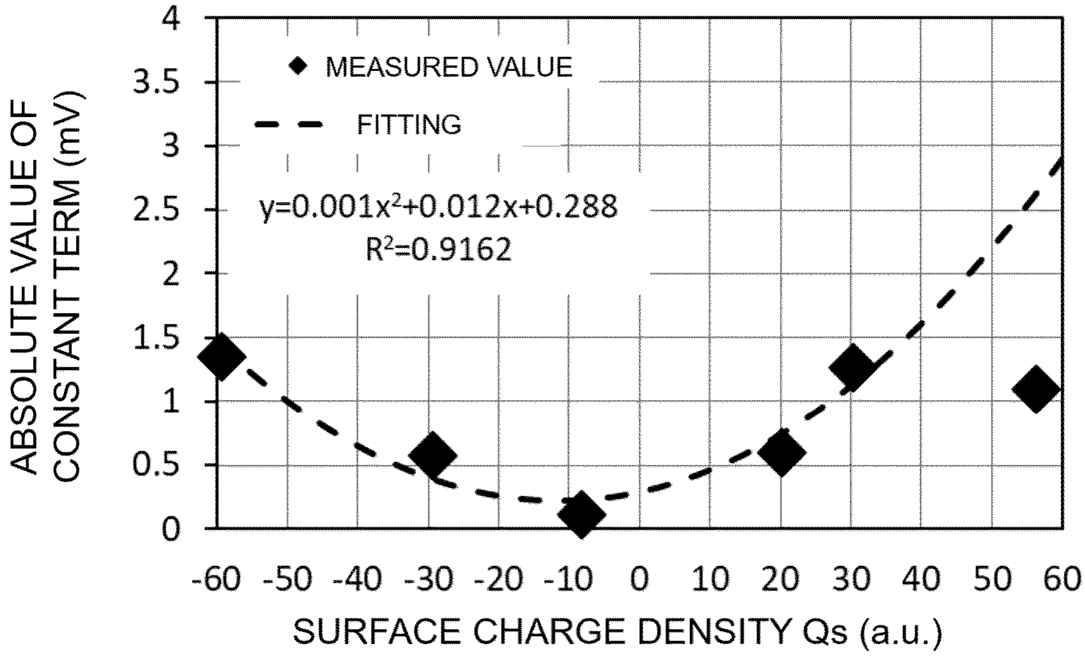
ABSOLUTE VALUE OF CONSTANT TERM (mV)
4
3.5
3
2.5
2
1.5
1
0.5
0
MEASURED VALUE
FITTING
y=0.001x²+0.012x+0.288
R²=0.9162
-60 -50 -40 -30 -20 -10 0 10 20 30 40 50 60
SURFACE CHARGE DENSITY Qs (a.u.)

Fig. 11

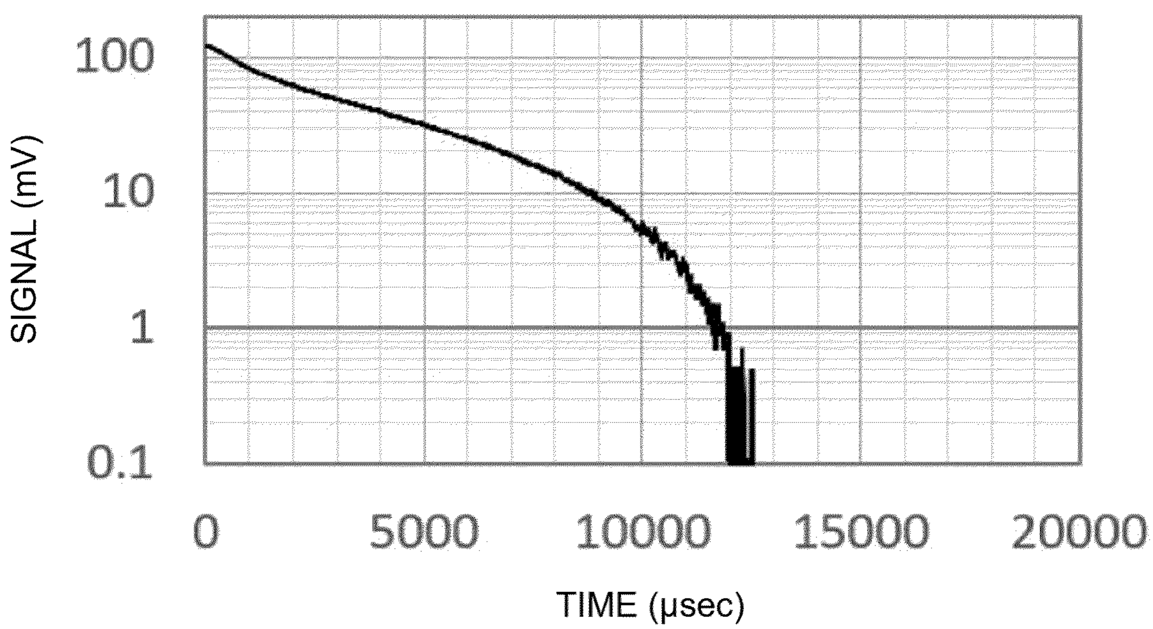
SIGNAL (mV)
100
10
1
0.1
0 5000 10000 15000 20000
TIME (μsec)

Fig. 12

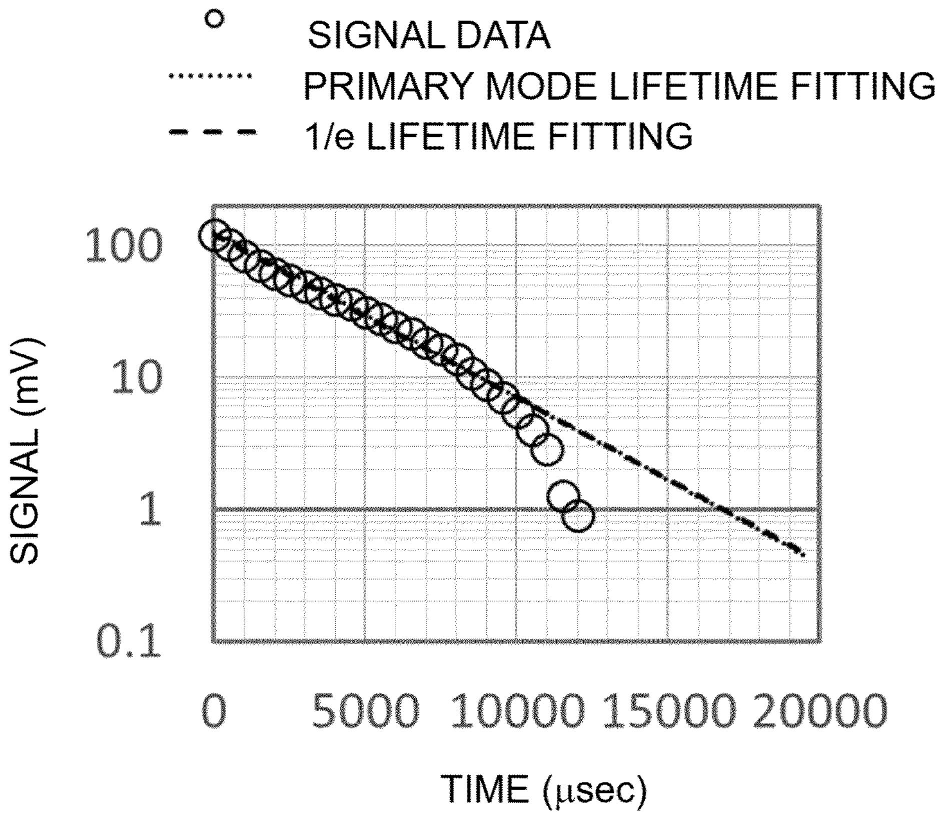
SIGNAL DATA
PRIMARY MODE LIFETIME FITTING
1/e LIFETIME FITTING
100
10
1
0.1
SIGNAL (mV)
0
5000
10000
15000
20000
TIME (μsec)

**INTERNATIONAL SEARCH REPORT**

International application No. **PCT/JP2023/006650**

**A. CLASSIFICATION OF SUBJECT MATTER**

***H01L 21/66***(2006.01)i
FI: H01L21/66 M

According to International Patent Classification (IPC) or to both national classification and IPC

**B. FIELDS SEARCHED**

Minimum documentation searched (classification system followed by classification symbols)

H01L21/66

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2012-195531 A (KABUSHIKI KAISHA KOBE SEIKO SHO) 11 October 2012 (2012-10-11) entire text | 1-19 |
| A | JP 57-54338 A (IKUTOKU KOGYO DAIGAKU) 31 March 1982 (1982-03-31) entire text | 1-19 |
| A | JP 59-55013 A (MITSUBISHI KINZOKU KK) 29 March 1984 (1984-03-29) entire text | 1-19 |
| A | JP 2019-12740 A (KYOCERA CORPORATION) 24 January 2019 (2019-01-24) entire text | 1-19 |
| A | JP 2013-145868 A (TOKYO UNIV. OF AGRICULTURE & TECHNOLOGY) 25 July 2013 (2013-07-25) entire text | 1-19 |
| A | JP 2013-197364 A (SHIN-ETSU HANDOTAI CO., LTD.) 30 September 2013 (2013-09-30) entire text | 1-19 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **03 April 2023** | **18 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2023/006650**

**C. DOCUMENTS CONSIDERED TO BE RELEVANT**

| Category* | Citation of document, with indication, where appropriate, of the relevant passages | Relevant to claim No. |
|---|---|---|
| A | JP 2013-26461 A (SEMICONDUCTOR ENERGY LAB. CO., LTD.) 04 February 2013 (2013-02-04) entire text | 1-19 |
| A | JP 2016-1676 A (GLOBALWAFERS JAPAN CO., LTD.) 07 January 2016 (2016-01-07) entire text | 1-19 |

Form PCT/ISA/210 (second sheet) (January 2015)

**INTERNATIONAL SEARCH REPORT**
**Information on patent family members**

International application No.
**PCT/JP2023/006650**

| Patent document cited in search report | Publication date (day/month/year) | Patent family member(s) | Publication date (day/month/year) |
|---|---|---|---|
| JP 2012-195531 A | 11 October 2012 | (Family: none) | |
| JP 57-54338 A | 31 March 1982 | (Family: none) | |
| JP 59-55013 A | 29 March 1984 | (Family: none) | |
| JP 2019-12740 A | 24 January 2019 | (Family: none) | |
| JP 2013-145868 A | 25 July 2013 | (Family: none) | |
| JP 2013-197364 A | 30 September 2013 | (Family: none) | |
| JP 2013-26461 A | 04 February 2013 | (Family: none) | |
| JP 2016-1676 A | 07 January 2016 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019012740 A
- JP S58181549 A


### Non-patent literature cited in the description


- **AKIRA USAMI** ; **FUKUYASU SONE** ; **KOJI MURAI** ; **KENJI SANO**. *Laser Research*, 1984, vol. 12 (10), 585-594
- **AKIRA USAMI** ; **SHINICHI KANDATSU** ; **TAKESHI KUDO**. *Applied Physics*, 1980, vol. 49 (12), 1192-1197